# EUROPEAN PATENT APPLICATION

(11) **EP 1 568 799 A1**
(43) Date of publication of application: **31.08.2005**
(21) Application number: 03777199.5
(22) Date of filing: 03.12.2003
(51) Int. Cl.: C23C 26/00, H01L 23/02, H05K 5/00

(54) **METAL MATERIAL FOR ELECTRIC ELECTRONIC COMPONENT**

(30) Priority: 03.12.2002 JP 2002351353
(71) Applicant: THE FURUKAWA ELECTRIC CO., LTD., Tokyo 100-8322 (JP)
(72) Inventor: TANI, Toshio, c/o THE FURUKAWA ELECTRIC CO. LTD., Tokyo 100-8322 (JP); SUZUKI, Satoshi, c/o THE FURUKAWA ELECTRIC CO. LTD, Tokyo 100-8322 (JP); MESAKI, Masakazu, THE FURUKAWA ELECTRIC CO. LTD., Tokyo 100-8322 (JP)
(74) Representative: Larsson, Karin
(86) International application number: PCT/JP2003/015467
(87) International publication number: WO 2004/050950

(57) **Abstract**

A metallic material for electric or electronic parts containing a resin film on or over at least a part of a metallic substrate, and an electric or electronic part using the metallic material.

## Description

### TECHNICAL FIELD

The present invention relates to a metallic material suitable for electric or electronic parts (casings, cases, covers, caps or the like), such as low profile casings comprising therein elements mounted on a printed board or the like of electric or electronic machinery and tools, in particular, a portable equipment or the like.

### BACKGROUND ART

An individual part that is to be mounted on a printed board or the like of electric or electronic machinery and tools, such as a ceramic oscillator, a quartz oscillator, a voltage-controlled oscillator, an SAW filter, a diplexer, a coupler, a balun, an LPF, a BPF, or a dielectric duplexer; and various module parts each comprising therein plurality of the above-mentioned elements (such as an antenna switch module, a front end module, an RF-integrated module, a bluetooth module, an image sensor module, and a tuner module), as well as detecting switches or other parts, are each used by being put into a metallic casing or covered with a cover, for electromagnetic shielding. As the tendency of making electric or electronic machinery and tools portable advances further, the casing or the like is required to be made thinner and smaller in height. The height thereof is becoming 5 mm or less for module parts, and it is becoming less than 2 mm, so as to be approximately 1 mm, for individual parts.

However, the above-mentioned metallic casing or the like have the drawback that the internal volume thereof becomes smaller as the height thereof becomes smaller, and consequently, an insulating property cannot be sufficiently ensured between the electric or electronic part, such as a case, cover, cap, or casing (a case with a cover), and parts built therein.

In such a case, there has been performed a method of cutting an insulating film into the form of a sheet having a given size, and then inserting the sheet into a case. However, the method has the problem that costs increase, and the production process is also complicated.

Other and further features and advantages of the invention will appear more fully from the following description, taken in connection with the accompanying drawings.

### BRIEF DESCRIPTION OF DRAWINGS

Fig 1 is an enlarged sectional view illustrating a first embodiment of the metallic material for electric or electronic parts of the present invention.
Fig 2 is an enlarged sectional view illustrating a second embodiment of the metallic material for electric or electronic parts of the present invention.
Fig 3 is an enlarged sectional view illustrating a third embodiment of the metallic material for electric or electronic parts of the present invention.
Fig. 4 is an enlarged sectional view illustrating a fourth embodiment of the metallic material for electric or electronic parts of the present invention.
Fig. 5 is an enlarged sectional view illustrating a fifth embodiment of the metallic material for electric or electronic parts of the present invention.
Fig. 6 is an enlarged sectional view illustrating a sixth embodiment of the metallic material for electric or electronic parts of the present invention.
Fig 7 is an enlarged sectional view illustrating a seventh embodiment of the metallic material for electric or electronic parts of the present invention.
Fig 8 is an enlarged sectional view illustrating an eighth embodiment of the metallic material for electric or electronic parts of the present invention.
Fig 9 is a plan view illustrating a ninth embodiment of the metallic material for electric or electronic parts of the present invention.
Fig. 10 is a plan view illustrating a tenth embodiment of the metallic material for electric or electronic parts of the present invention.

### DISCLOSURE OF INVENTION

The present invention resides in a metallic material for electric or electronic parts comprising a resin film on or over at least a part of a metallic substrate.

Further, the present invention resides in an electric or electronic part using the above-mentioned metallic material for electric or electronic parts.

### BEST MODE FOR CARRYING OUT THE INVENTION

According to the present invention, there is provided the following means:
(1) A metallic material for electric or electronic parts comprising a resin film on or over at least a part of a metallic substrate.
(2) The metallic material for electric or electronic parts according to item (1), comprising at least one metallic layer on or over the metallic substrate, wherein the resin film is directly formed on the metallic substrate, or is formed over the metallic substrate so as to interpose at least one metallic layer therebetween.
(3) The metallic material for electric or electronic parts according to item (1) or (2), wherein the metallic substrate or the metallic layer is subjected to an undercoat treatment.
(4) The metallic material for electric or electronic parts according to any one of items (1) to (3), wherein the height from the surface of the metallic substrate to the surface of the resin film is 60 µm or less.
(5) An electric or electronic part, wherein the metallic material for electric or electronic parts according to any one of items (1) to (4) is used.

The inventors, having made eager investigations on insulation properties of materials for electric or electronic parts, have found out that a heat-resistant resin film forms in an area where insulation is required on a metallic substrate, so that the insulating property can be sufficiently kept between the substrate and built-in parts. The present invention has been made based on this finding.

The present invention will be further explained hereinafter.

The metallic material for electric or electronic parts of the present invention comprises a resin film on or over at least a part of a metallic substrate. The part having the resin film is preferably an area where insulation is required In a preferred embodiment, the resin film is formed only in the area where insulation is required. The resin film is preferably a heat-resistant resin film

The "electric or electronic part", wherein the metallic material of the present invention is used, may be, for example, a casing, a case, a cover or a cap, but is not limited thereto. The "electric or electronic part" is more preferably a low-plofile casing into which an element should be incorporated In the case that the metallic material of the present invention is made into, for example, a casing, it is preferred to form the casing in the state that the surface of the metallic substrate where the heat-resistant resin film is to be formed is faced inwards.

Examples of the element which is preferably incorporated into an electric or electronic part wherein the metallic material of the present invention is used include individual elements which are to be mounted on a printed board of portable equipment or the like, such as a ceramic oscillator, a quartz oscillator, a voltage-controlled oscillator, an SAW filter, a diplexer, a coupler, a balun, an LPF, a BPF and a dielectric duplexer, various module parts each comprising therein plural ones of these individual elements (such as an antenna switch module, a front end module, an RF-integrated module, a bluetooth module, an image sensor module and a tuner module); and detecting switches. However, the incorporated element is not limited thereto

The "area where insulation is required" in the present invention means a place where the metallic material constituting a part case and an element or electric wiring circuit inside the part need to be prevented from being electrically short-circuited by insulating this place.

In the present invention, the metallic material indicates a metal the shape of which may be various. In particular, the metallic material mainly indicates a metal sheet or metal strip

Further, the electric or electronic part, wherein the metallic material of the present invention, is used can be used in electronic or electric machinery and tools, for example, a cellular phone, a personal digital assistant, a notebook-sized personal computer, a digital camera, or a digital video However, the electronic or electric machinery and tools are not limited thereto

In the present invention, examples of the method for forming the heat-resistant resin film on the metallic substrate or the like include a method of a method (a) of arranging a heat-resistant resin film with an adhesive agent onto the place where insulation is required, melting the adhesive agent with an induction heating roll, and then treating the resultant thermally, thereby reacting, curing and connecting them, and a method (b) of applying a varnish wherein a resin or resin precursor is dissolved in a solvent onto the place where insulation is required, volatizing the solvent, and then treating the resultant thermally, thereby reacting, curing and connecting them.

The method (a) is recommendable since the heat-resistant resin film can be positioned on the metallic substrate with a high precision In the method (b), a high precision can be attained depending on a manner and a device that are adopted. For example, a production manner corresponding to the level of the formation precision of the resin film can be adopted from, for example, the following the manner of applying roll coating facilities of offset (lithographic) printing or gravure (intaglio) printing to the place to be painted; the manner of applying coating with a photosensitive heat-resistant resin, the formation of a pattern by ultraviolet rays or an electron beam, and a technique for curing the resin; and the application of a technique for forming a fine pattern in a circuit board by exposure, development, etching and dissolution to the resin film. The tolerance of the position where the heat-resistant resin film is formed on the metallic substrate is preferably ± 0.15 mm, more preferably ± 0.10 mm, furthermore preferably ± 0.05 mm, considering that the metallic material can be applied to many parts.

In the present invention, a material having such ductility that punching work, draw forming or the like can be attained, or a material having springing property can be used as the metallic substrate Specific examples thereof include Cu-series materials, such as nickel silver (Cu-Ni-series alloy), phosphorus bronze (Cu-Sn-P-series alloy), and Fe-series materials, such as 42-alloy (Fe-Ni-series alloy), and stainless steel Of these, phosphorus bronze is preferred

In the present invention, the electric conductivity of the metallic substrate is preferably 5% IACS or more, more preferably 10% IACS or more from the viewpoint of electromagnetic shield. The relative magnetic permeability is preferably 1 or more. The thickness of the metallic substrate is preferably from 0.01 to 0.5 mm, more preferably from 0.05 to 0.2 mm.

The metallic substrate can be produced in a usual manner, for example, by melting and casting a given metallic material and then subjecting the resultant ingot to hot rolling, cold rolling, homogenizing and degreasing steps in this order

As the resin which constitutes the heat-resistant resin film in the present invention, for example, a polyimide-series, polyamideimide-series, polyamide-series or epoxy-series resin, or the like may be used As the heat-resistant resin, particularly a polyimide or polyamideimide-series resin is preferred.

With respect to the insulating property of the heat-resistant resin film, the volume specific resistance thereof is preferably 10¹⁰ Ω·cm or more, more preferably 10¹⁴ Ω·cm or more

In the case that an adhesive agent is used to deposit the heat-resistant resin film on the metallic substrate, a polyimide-series, epoxy-series, acrylic-series or silicone-series resin, or the like can be used. These resins have heat resistance to heating steps, such as solder connecting and reflow solder mounting In uses under which heating conditions are not severe, it is allowable to use a resin having a small heat-resistance (such as a phenol-series, polyamide-series, or polyethylene terephthalate-series resin), other than the above-mentioned resins.

If the thickness of the heat-resistant resin film is too small, sufficient insulating property is not obtained and further pinholes are easily generated. Accordingly, the thickness is preferably 2 µm or more, more preferably 3 µm or more On the other hand, if the thickness is too large, the formability into a casing or the like deteriorates Accordingly, the thickness is preferably 50 µm or less, particularly preferably less than 15 µm.

In the present invention, it is also preferred that at least one metallic layer forms on or over the metallic substrate, and the heat-resistant resin film forms directly on the metallic substrate or forms over the metallic substrate so as to interpose at least one layer of the metallic layer(s) therebetween.

The metallic layer(s) may be formed into the form of a single layer or plural layers For example, in the case of a use which is to be subjected to solder connecting, the thickness of the outermost metallic layer out of the above-mentioned metallic layers is preferably made into 1 µm or more, which causes the wettability to a solder to be satisfactorily kept and makes melt-connecting, such as reflow solder connecting, possible. The upper limit thereof is about 20 µm Even if the thickness is made more than the limit, the advantageous effects are saturated. In uses other than it, the thickness of the outermost metallic layer is preferably from 0.1 to 10 µm in view of corrosion resistance, resin adhesion property or the like With respect to the metallic layers other than the outermost layer also, the thickness thereof preferably ranges from 0.1 to 10 µm

In the case of the plural layers, the number of the layers is more preferably 2 from the viewpoint of cost performance The thickness of each of the layers of the multi-layered structure is preferably from 0.1 to 10 µm

The material of the metallic layer(s) formed on the metallic substrate is decided depending on the material of the metallic substrate, the kind and use of a material-used part, required characteristics, allowable costs, and the like In all cases, however, a metal satisfying the basic necessary characteristics required in the present invention is selected. In the metallic layer(s), there can be generally used at least one metal from Ni, Cu, Sn, Ag, Pd and Au, or an alloy, eutectic material or compound comprising at least one of the above-mentioned metals..

In view of cost performance, in the case of the single layer film, it is preferred to use any series (metal, alloy, eutectic material or compound) of Ni, Sn or Ag In the case of the plural-layered film, it is preferred to use any series of Ni or Cu in the inner layer side (undercoat) and use any series of Sn, Ag, Pd or Au in the outer layer side. In the case that the metallic layers are three or more layers, it is preferred to use any series of Cu, Ag or Pd in the intermediate layer(s)

An alloy can be used in the Ni-series or Cu-series undercoat layer also. It is sufficient that the structure thereof is made of a simple substance or a simple-substance plural-layer. If the thickness is too small, many pinholes are generated If the thickness is too large, cracks are easily generated at the time of processing. Accordingly, the thickness is preferably from about 0.1 to 2 µm

A structure wherein its undercoat is made into one or more films of any series of Ni or Cu and its outer layer is made into a Sn-series film is widely used since the structure satisfies general necessary characteristics and is economical.

For the Sn-series film, a lusterless film is more suitable than a lustrous film Any series (metal, alloy, eutectic material or compound) of Sn, Sn-Cu, Sn-Ag, Sn-Bi or Sn-Zn can be used. For the others than Sn-Bi, a composition close to that of eutectic crystal, which has a low melting point, is easily used.

Sn, and Sn-Cu-series and Sn-Ag-series alloys are particularly good in heat resistance.

The Sn-Cu-series or Sn-Ag-series film can be laid by forming a Cu layer or Ag layer thinly on a Sn film and then alloying them when they are melted, as well as by alloy-film-formation.

The metallic layer(s) is/are generally formed by a wet process after the formation of the heat-resistant resin film.

Examples of the wet process include a dipping substitution treatment method, an electroless plating method, and an electrodeposition method. Of these, the electrodeposition method is good in thickness uniformity of the metallic layer, thickness controllability, stability of the bath therefor or the like. Total costs are also low.

The electrodeposition is performed by constant-current electrodeposition using a commercially available bath or a known plating solution and giving the plating solution to the space between the metallic substrate as a cathode and a soluble or insoluble anode at an appropriate relative speed.

In order to form the metallic layer(s) partially, a method of masking unnecessary areas, a method of supplying a plating solution, in spots, only into necessary areas, or some other method can be used.

In the present invention, the metallic layer(s) may be formed only in necessary areas, such as areas to be soldered, and the other areas may be made into the state that the metallic substrate is exposed.

In the present invention, it is preferred to subject the metallic substrate or the metallic leyer(s) to undercoat treatment for organic and inorganic bonds, a typical example thereof being a coupling treatment such as a silane coupling treatment and a titanate coupling treatment. When the metallic substrate or the metallic layer(s) is/are subjected to, for example, silane coupling treatment, adhesion property is improved between the metallic substrate or the metallic layer(s) and the heat-resistant resin film.

For example, the silane coupling treatment is generally conducted by dipping the metallic substrate into a solution wherein a silane coupling agent is dissolved in water. As the silane coupling agent, one suitable for the bonding of the heat-resistant resin film or resin film to be used is selected from commercially available agents An epoxy-series silane coupling agent is particularly recommendable.

In the present invention, the height from the surface of the metallic substrate to the surface of the resin film is preferably 60 µm or less, more preferably from 2 to 30 µm. If this thickness is too large, the metallic material of the present invention is unsuitable for low-profile parts and further precision in part-formation deteriorates.

Referring to the drawings, preferred embodiments of the electric or electronic part metallic material of the present invention will be explained in detail hereinafter. The invention is by no means limited to these embodiments.

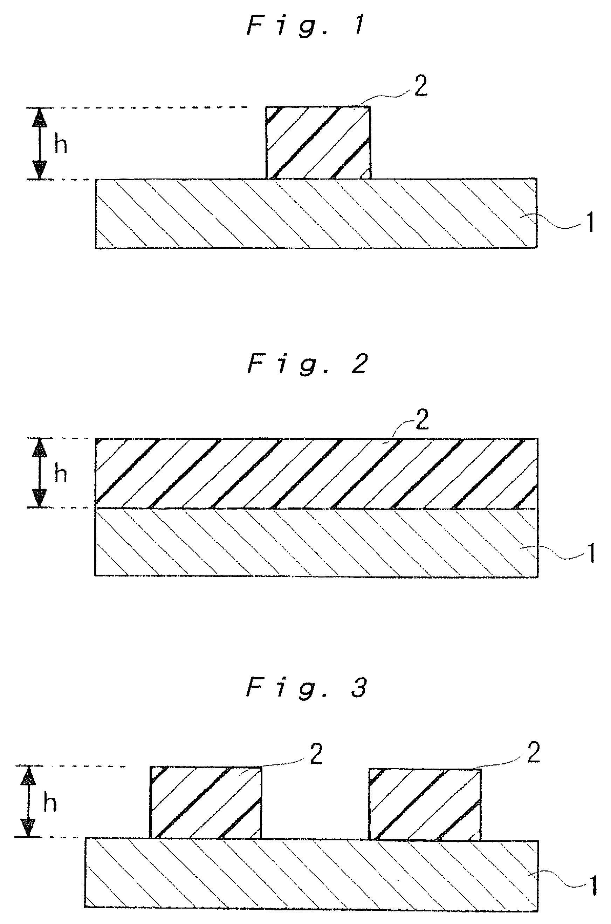

Fig. 1 is an enlarged sectional view illustrating a first embodiment of the metallic material of the present invention. A heat-resistant resin film 2 is formed on a surface of a metallic substrate 1 and in at least one place where insulation is required. The height from the substrate surface to the surface of the heat-resistant resin film is represented by "h" (which is applied similarly to the following Figs. 2 to 8).

Fig. 2 is an enlarged sectional view illustrating a second embodiment of the metallic material of the present invention. A heat-resistant resin film 2 is formed on the whole of a single surface of a metallic substrate 1.

Fig. 3 is an enlarged sectional view illustrating a third embodiment of the metallic material of the present invention. A heat-resistant resin film 2 is formed on a surface of a metallic substrate 1 and in two places where insulation is required.

In the metallic materials of the present invention illustrated in Figs 1, 2 and 3, the heat-resistant resin film 2 is arranged on the place(s) where insulation is required, to thereby keep satisfactorily the insulating property between a casing comprised of the metal substrate and a part built therein. Therefore, the metallic materials are favorable for reducing the profile of the casing Since the metallic substrate is exposed in the place where the heat-resistant resin film 2 is not provided in Figs 1 and 3, high heat-radiating property is kept.

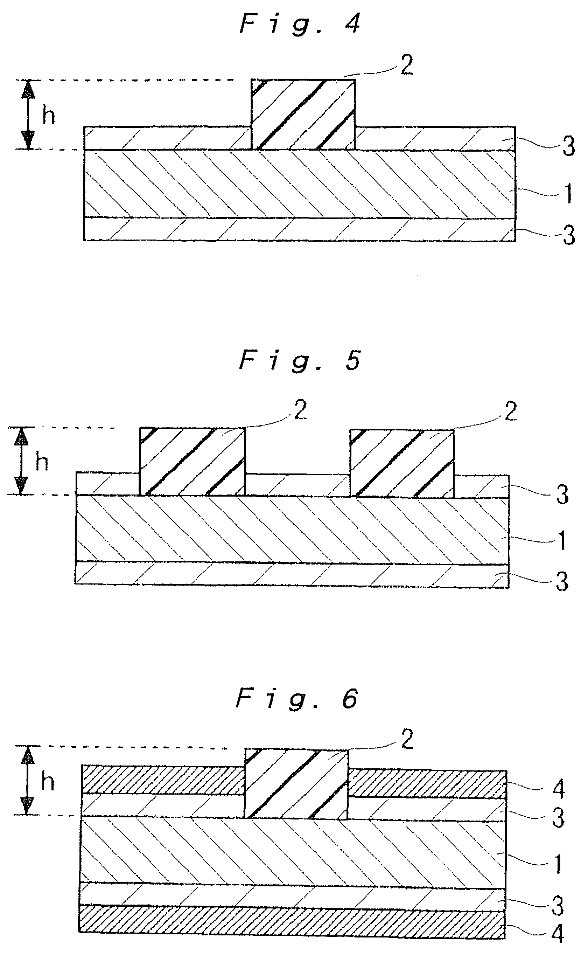

Fig. 4 is an enlarged sectional view illustrating a fourth embodiment of the metallic material of the present invention. A heat-resistant resin film 2 is formed on a surface of a metallic substrate 1 and in at least one place where insulation is required. A Ni layer 3 is formed on the metallic substrate and in places other than the place where the heat-resistant resin film 2 is formed.

Fig. 5 is an enlarged sectional view illustrating a fifth embodiment of the metallic material of the present invention. A heat-resistant resin film 2 is formed on a surface of a metallic substrate 1 and in at least one place on two places where insulation is required. A Ni layer 3 is formed on the metallic substrate and in places other than the places where the heat-resistant resin film 2 is formed.

In the metallic materials illustrated in Figs. 4 and 5, the Ni layer 3 is formed on the metallic substrate 1 and in places other than the place(s) where the heat-resistant resin film 2 is formed, therefore, the corrosion resistance thereof is improved.

Fig 6 is an enlarged sectional view illustrating a sixth embodiment of the metallic material of the present invention. A heat-resistant resin film 2 is formed on a surface of a metallic substrate 1 and in at least one place where insulation is required. A Ni layer 3 and a Sn layer 4 are formed, in this order, on/over the metallic substrate 1 and in places other than the place where the heat-resistant resin film 2 is formed.

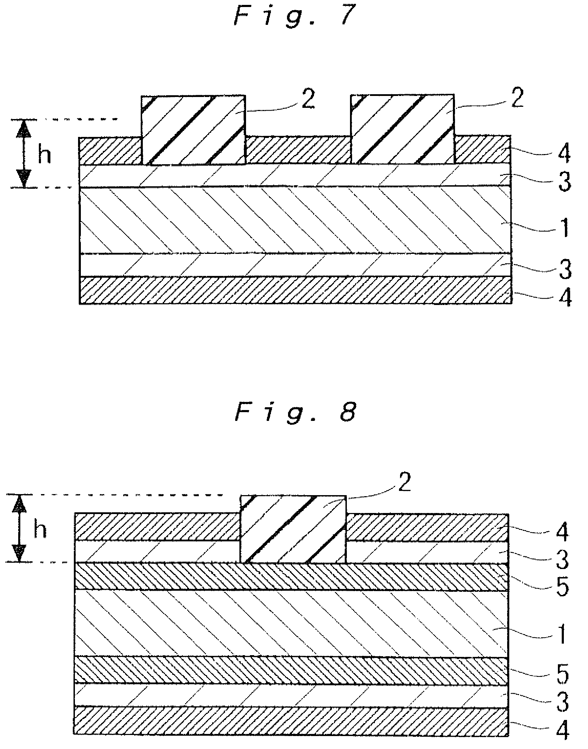

Fig. 7 is an enlarged sectional view illustrating a seventh embodiment of the metallic material of the present invention. A Ni layer 3 is formed on a metallic substrate 1. A heat-resistant resin film 2 is formed thereon and in two places where insulation is required. A Sn layer 4 is formed over the metallic substrate 1 and in places other than the places where the heat-resistant resin film 2 is formed.

In the metallic materials of the present invention illustrated in Figs. 6 and 7, the Sn layer 4 is formed over the metallic substrate 1 and in places other than the place(s) where the heat-resistant resin film 2 is formed, therefore, solder connecting or reflow solder mounting can easily be performed. Since the Ni layer 3 hinders parts of the metallic substrate 1 from diffusing, the discoloration of the Sn layer 4 is prevented. Additionally, with respect to the metallic material of the present invention illustrated in Fig 7, the effect of improving the adhesion property between the substrate 1 and the heat-resistant resin film 2 is obtained since the film 2 is formed on the Ni layer 3.

In the metallic material of the present invention wherein two metallic layers are formed as illustrated in Fig 6 or 7, the metallic substrate 1 is satisfactorily protected and the heat resistance, oxidation resistance and corrosion resistance of the metallic substrate 1 are improved. It is also possible to restrain the outer layer of the metallic layers from being alloyed or being conversed into a compound by the diffusion of parts of the metallic substrate 1.

In particular, in the metallic material wherein a Ni layer or Cu layer is formed as an undercoat and a Sn layer is formed as an outer layer, the Sn layer is sufficiently restrained from being conversed into a compound so that the heat resistance and whisker resistance are kept at a high level. Thus, the metallic material is recommendable. When three or more metallic layers are formed, a further effect is produced However, it is appropriate that the number of the metallic layers is two from the viewpoint of cost performance.

Fig. 8 is an enlarged sectional view illustrating an eighth embodiment of the metallic material of the present invention. A metallic substrate 1 is subjected to an undercoat treatment for organic or inorganic bonds, a typical example of which is a coupling treatment such as silane coupling treatment or titanate coupling treatment. A heat-resistant resin film 2 is formed on a layer 5 obtained by the treatment and in one place where insulation is required. A Ni layer 3 and a Sn layer 4 are formed, in this order, over the metallic substrate 2 and in places other than the place where the heat-resistant resin film 2 is formed. Since the metallic substrate 1 is subjected to, for example, silane coupling treatment in this metallic material, the adhesion property between the metallic substrate 1 and the heat-resistant resin film 2 is improved.

Furthermore, a heat sink made of copper or the like may be formed in places where the heat-resistant resin film 2 is not formed in the metallic material of the present invention, so as to make the heat-radiating property thereof remarkably high. In particular, in the metallic materials illustrated in Figs 6 to 8, the heat sink can easily be connected thereto by soldering.

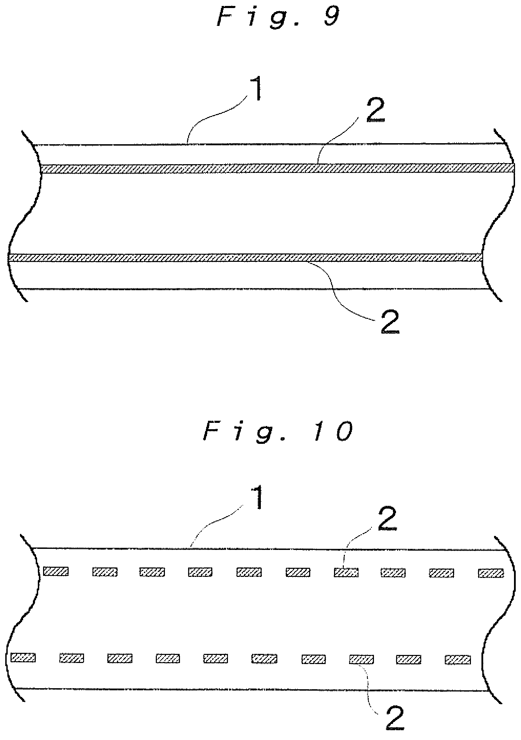

Fig. 9 is a plan view illustrating a ninth embodiment of the metallic material of the present invention A heat-resistant resin film 2 is formed, into a stripe form, on a metallic substrate 1 and in places where insulation is required. A Ni layer 3, or a Ni layer 3 and a Sn layer 4 may be formed, in this order, on the metallic substrate and in places other than the places where the heat-resistant resin film 2 is formed. It is also allowable to subject the metallic substrate 1 to an undercoat treatment for organic or inorganic bonds, a typical example of which is a coupling treatment such as a silane coupling treatment or a titanate coupling treatment, form the heat-resistant resin film 2 on a layer 5 obtained by the treatment and in a single place where insulation is required, and form a Ni layer 3 and a Sn layer 4, in this order, over the metallic substrate 2 and in places other than the place where the heat-resistant resin film 2 is formed.

Fig. 10 is a plan view illustrating a tenth embodiment of the metallic material of the present invention. A heat-resistant resin film 2 is formed, in spots, on a metallic substrate 1 and in places where insulation is required. Other things are equal to those of the ninth embodiment.

The metallic material for electric or electronic parts of the present invention comprises a resin film on or over at least a part of a metallic substrate, so that, for example, in the case that the metallic material is used as a casing in the state that the resin film is faced inwards, the insulating property between the casing and a part built therein can be sufficiently ensured. Accordingly, the profile of the casing can be reduced. Thus, it is useful for making portable equipment thinner. When the resin film is formed only in a place where insulation is required, the metallic substrate is exposed in any place where the resin film is not formed, so that high heat-radiating property is kept. Further, a metallic layer is formed in the exposed place of the metallic substrate, so that the solder connectability (solder reflow property), the heat resistance, the corrosion resistance and the like are improved. In a metallic material wherein a metallic layer is formed on the above-mentioned metallic substrate, the adhesion property between the layer and a resin film formed thereon is improved. Furthermore, a metallic material wherein the above-mentioned metallic substrate or metallic layer is subjected to an undercoat treatment, improves in the adhesion property between the substrate or layer and a resin film formed thereon. Accordingly, the present invention exhibits industrially remarkable effects. The present invention can be suitably used as a low-profile casing by setting the height from its metallic substrate surface to its resin film surface into 60 µm or less.

The present invention will be described in more detail based on the following examples, but the invention is by no means limited to these examples.

### EXAMPLES

### Example 1

A Cu-6% by mass Sn-0.2% by mass P alloy (phosphorus bronze, a JIS alloy number C7521 (nickel silver), and an Fe-42% by mass Ni alloy (42 alloy) were each melted and cast to prepare an ingot. The ingot was subjected to hot rolling followed by cold rolling to prepare strips having 0.1 mm thick and 20 mm wide. Each of the strips was subjected to respective steps of electrolytic degreasing, acid-washing treatment, water-washing, and drying in this order. Before the drying step, a part of the strips were dipped into a solution wherein an epoxy-series silane coupling agent was dissolved in water, thereby subjecting the strips to silane coupling treatment.

Next, a heat-resistant resin film having a thickness of 3 µm or more was formed on each of the dried strips and in a place where insulation was required by either of the following method (a) or method (b), to thereby manufacture samples Nos. 1 to 27.
(a) A varnish made of a polyimide solution or precursor solution or a polyamideimide solution or precursor solution, using n-methyl 2-pyrrolidone as a solvent, or an epoxy resin solution using methyl ethyl ketone as a solvent was applied, in a stripe form (width, 10 mm), to the central area in the width direction of a single surface of each of the strips (metallic substrates). Next, the solvent was removed or dehydration reaction was caused, and subsequently the resultant was subjected to a given heating treatment so as to be cured or polymerized, so that a heat-resistant resin film was formed. The thickness of the film was changed into various values.
(b) A heat-resistant polyimide resin film (thickness: 12.5 µm) to which an adhesive agent (thickness: 15 µm) was beforehand applied was slit into pieces 3 mm in width. Two out of the pieces were stuck, at an interval of 2 mm, onto the central area in the width direction of a single surface of each of the strips (metallic substrates). This was heated and pressed between two induction heating rolls, and further subjected to two-stage heating treatment so as to melt and cure the adhesive agent, to thereby attain connecting.

A part of the strip wherein the heat-resistant resin film was partially formed was used to examine the peel strength of the heat-resistant resin film from the metallic substrate by means of a Tensiron tester.

Next, a commercially available or known electroplating bath was used to plate the surface of the strip on which no heat-resistant resin film was formed with a metallic layer, thereby manufacturing a strip material (metallic material for electric or electronic parts). Next, the strip material was cut into short pieces. The pieces were each punched out into a form close to a 15-mm square or 5-mm square. This was subjected to draw forming into a cover.

A module part (the number of chips therein: 5, and the height: 2 mm) of a testing substrate was covered with the above-mentioned cover. A voltage of DC 100 V was applied to the module to examine the insulation resistance of the cover. Next, the testing substrate was continuously worked for 5 hours. Thereafter, the temperature of the inside of the cover was measured to examine the heat-radiating property of the cover. Furthermore, the cover was floated in a solder bath of 280°C temperature for 3 minutes, and then the external appearance thereof was observed to examine the reflow heat resistance.

These test results are shown in Table 1. In Table 1, the construction of each of the strip materials is also shown. In Table 1, "Painting" and "Film" in the column "Resin-forming method" show film-formation by the method (a) and the method (b), respectively. The "Polyimide", "Epoxy", "Acrylic", and "Silicone" each show the kind of the resin used in the adhesive agent in the method (b) in the column "Kind of adhesive agent" in Table 1.

### Example 2

A strip material (sample No. 28) was manufactured in the same manner as the samples Nos 8 to 20 in Example 1 except that no metallic layer was formed, and the same tests as in Example 1 were conducted. The test results and the construction of the strip material are shown in Table 1.

### Example 3

A strip material (sample No 29) was manufactured in the same manner as the sample No. 1 in Example 1 except that the thickness of the heat-resistant resin film was set to 2 µm, and the same tests as in Example 1 were conducted. The test results and the construction of the strip material are shown in Table 1.

### Example 4

A strip material (sample No. 30) was manufactured in the same manner as the sample No. 2 in Example 1 except that the method (a) in Example 1 was used to form the heat-resistant resin film on the whole of a single surface of the metallic substrate (single surface entirely-painting) and the thickness of the heat-resistant resin film was set to 7 µm. A strip material (sample No 31) was manufactured in the same manner as the sample No. 9 in Example 1 except that the method (a) in Example 1 was used to form the heat-resistant resin film on the whole of a single surface of the metallic substrate (single surface entirely-painting), the thickness of the heat-resistant resin film was set to 6 µm, and the thickness of the undercoat plating was set to 0.1 µm. These were subjected to the same tests as in Example 1. The test results and constructions of the strip materials are shown in Table 1.

### Comparative Example

The surface of each of the strips was merely electroplated, to thereby manufacture a strip material with a metallic layer (sample No. 32 or 33). The same test as in Example 1 was conducted. The test results and constructions of the strip materials are shown in Table 1.

In each of Examples and Comparative Examples, the height h (see Figs. 1 to 8) from the substrate surface to the surface of the heat-resistant resin film was set to 60 µm or less.

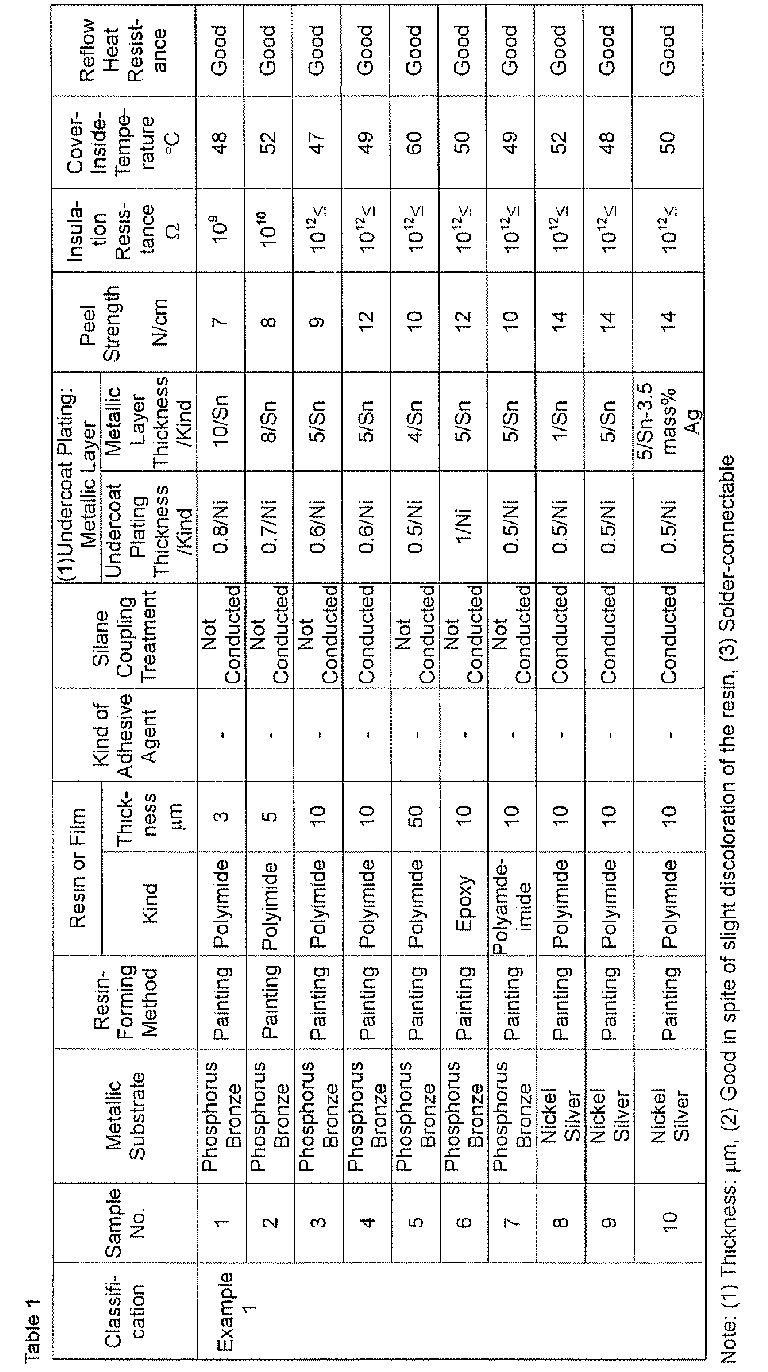

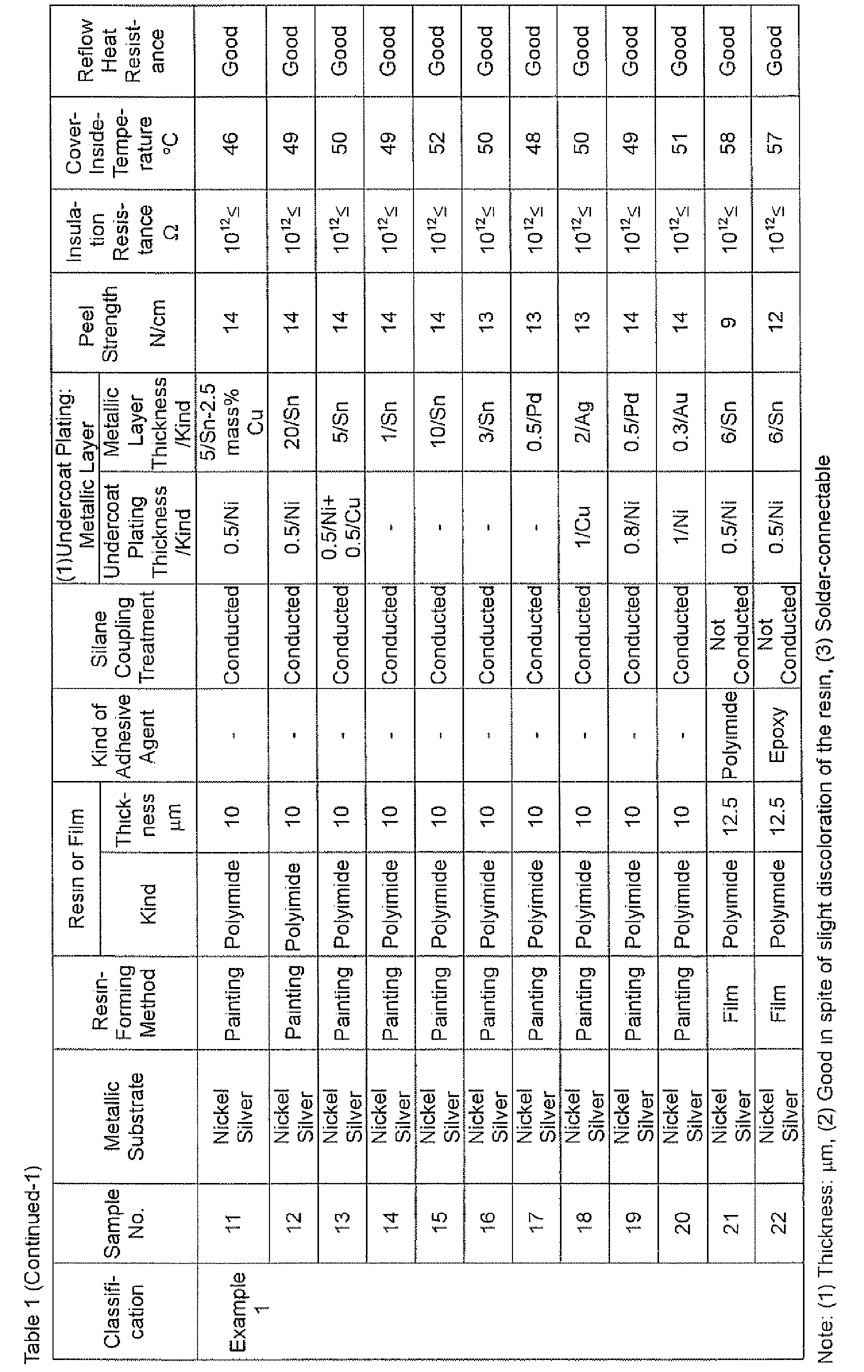

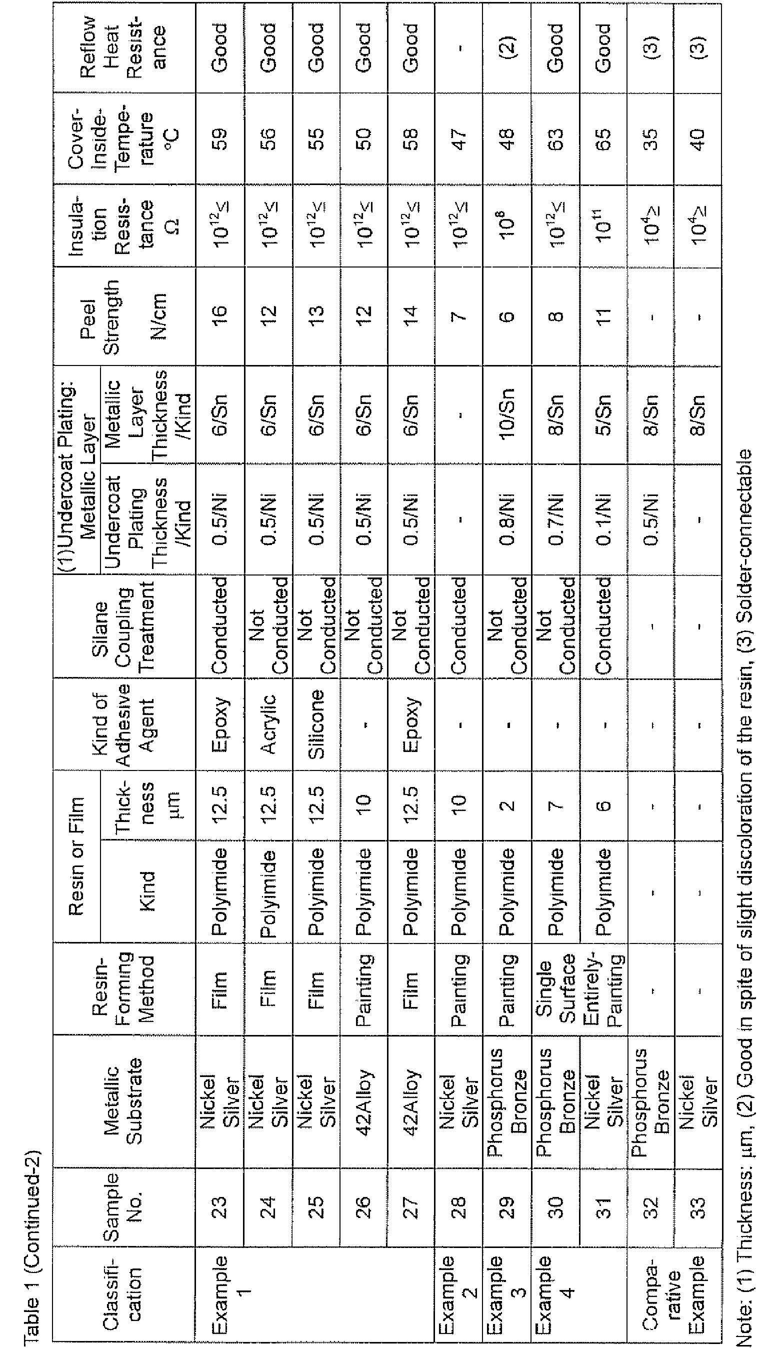

As is apparent from Table 1, the materials of Examples (Nos. 1 to 31) of the present invention were each high in the peel strength of the resin film and insulation resistance, low in the temperature of the inside of the cover, and good in reflow heat resistance.

When Nos. 3 and 4 are compared with each other as well as Nos. 22 and 23, it can be understood that when silane coupling treatment is conducted before the formation of a resin, the peel strength is improved.

The material of Example 2 (No. 28) was a material wherein no metallic layer was formed on the surface of the metallic substrate, and exhibited characteristics equivalent to those of Example 1 in insulation resistance and cover-inside-temperature. The peel strength was somewhat lower than that of Nos. 8 to 20, but was at such a level that no practical trouble would be caused.

In the material of Example 3 (No. 29), the thickness of the heat-resistant resin film was relatively small so that the peel strength and the insulation resistance were somewhat lowered. The resin was discolored but the discoloration was at such a level that no practical trouble would be caused.

In the materials of Example 4 (Nos. 30 and 31), the heat-resistant resin film was formed on the whole of the single surface of the metallic substrate; therefore, the cover-inside-temperature was slightly high but the materials had no functional problem and were practical. On the other hand, in the materials of Comparative Examples (Nos. 32 and 33), no heat-resistant resin film was formed; therefore, the materials were poor in insulating property and were each incapable of coping with decrease in the height of casings.

### INDUSTRIAL APPLICABILITY

The metallic material for electric or electric parts of the present invention makes it possible to realize reduction in the profile of casings and is useful for making portable equipment thinner.

The metallic material for electric or electric parts of the present invention is also suitable for, for example, a low-profile casing for having a built-in part mounted on a printed board or the like.

Having described our invention as related to the present embodiments, it is our intention that the invention not be limited by any of the details of the description, unless otherwise specified, but rather be construed broadly within its spirit and scope as set out in the accompanying claims.

## Claims

1. A metallic material for electric or electronic parts comprising a resin film on or over at least a part of a metallic substrate.

2. The metallic material for electric or electronic parts according to claim 1, comprising at least one metallic layer on or over the metallic substrate, wherein the resin film is directly formed on the metallic substrate, or is formed over the metallic substrate so as to interpose at least one metallic layer therebetween.

3. The metallic material for electric or electronic parts according to claim 1 or 2, wherein the metallic substrate or the metallic layer is subjected to an undercoat treatment.

4. The metallic material for electric or electronic parts according to any one of claims 1 to 3, wherein the height from the surface of the metallic substrate to the surface of the resin film is 60 µm or less.

5. An electric or electronic part, wherein the metallic material for electric or electronic parts according to any one of claims 1 to 4 is used.
